(19) Europäisches Patentamt / European Patent Office / Office européen des brevets

(11) **EP 4 299 550 A1**

(12) **EUROPEAN PATENT APPLICATION**
published in accordance with Art. 153(4) EPC

(43) Date of publication:
**03.01.2024 Bulletin 2024/01**

(21) Application number: **22779629.9**

(22) Date of filing: **18.02.2022**

(51) International Patent Classification (IPC):
**C04B 38/00** $^{(2006.01)}$     **H05K 3/20** $^{(2006.01)}$

(52) Cooperative Patent Classification (CPC):
**C04B 38/00; H05K 3/20**

(86) International application number:
**PCT/JP2022/006515**

(87) International publication number:
**WO 2022/209402 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2021   JP 2021058650**

(71) Applicant: **Denka Company Limited**
**Tokyo 103-8338 (JP)**

(72) Inventors:
• **INOUE, Saori**
  **Tokyo 103-8338 (JP)**
• **YAMAGATA, Toshitaka**
  **Tokyo 103-8338 (JP)**
• **KANEKO, Eri**
  **Tokyo 103-8338 (JP)**
• **YOSHIMATSU, Ryo**
  **Tokyo 103-8338 (JP)**
• **KOGA, Ryuji**
  **Tokyo 103-8338 (JP)**

(74) Representative: **Gulde & Partner**
**Patent- und Rechtsanwaltskanzlei mbB**
**Wallstraße 58/59**
**10179 Berlin (DE)**

(54) **METHOD FOR MANUFACTURING CIRCUIT BOARD AND CIRCUIT BOARD**

(57)     A method of producing a circuit board of the present invention includes a step of placing, on a semi-cured composite sheet (10), a plate-shaped member (30) having an opening (31); a step of fitting a metal foil cut product (20) into the opening (31) of the plate-shaped member (30) and placing the metal foil cut product (20) on the semi-cured composite sheet (10) on which the plate-shaped member (30) has been placed; a step of pressurizing, while heating, the semi-cured composite sheet (10) on which the plate-shaped member (30) and the metal foil cut product (20) have been placed to produce a first laminate; and a step of removing the plate-shaped member (30) from the first laminate to produce a second laminate, where the absolute value of the difference between the thickness of the metal foil cut product (20) and the thickness of the plate-shaped member (30) is 0.25 mm or less, and the dielectric breakdown voltage is 3.5 kV or more. According to the present invention, it is possible to provide a method of producing a circuit board capable of suppressing occurrence of cracks in a semi-cured composite sheet that contains a porous ceramic and a semi-cured product of a thermosetting composition filling voids of the porous ceramic even when a metal foil cut product obtained by cutting a metal foil is attached to the semi-cured composite sheet and pressure is applied thereto.

EP 4 299 550 A1

# Fig. 1

**Description**

Technical Field

The present invention relates to a method of producing a circuit board and a circuit board obtained by the production method, and more particularly to a method of producing a circuit board used in a power module and a circuit board obtained by the production method.

Background Art

Power conversion devices are indispensable for electric transportation equipment such as hybrid vehicles, electric vehicles, and railways, home appliances such as air conditioners that use motors, and industrial equipment. Of the power conversion devices, a power semiconductor element can be exemplified as a device with high conversion efficiency. The power semiconductor element serves as an electrically controlled switch in a power conversion circuit to maintain an on/off state and to make a state transition between on and off. The power semiconductor element blocks current from a power source or a load in an off state, and passes current from the power source or load in an on state. A metal base substrate, for example, is used as a substrate on which such a power semiconductor element is mounted in order to ensure excellent heat dissipation and insulation properties. The metal base substrate is, for example, a laminated plate obtained by bonding a metal foil to one side of a metal base plate using an inorganic filler-containing epoxy resin (see, for example, PTL 1). The metal base substrate has excellent heat dissipation properties and the production cost thereof is lower than that of a ceramic substrate.

In recent years, the density of power modules equipped with a plurality of power semiconductor elements has been increasing year by year, and there is a demand for further improvements in the heat dissipation of metal base substrates on which power semiconductor elements are mounted. However, in the inorganic filler-containing epoxy resin in the metal base substrate described in PTL 1, an epoxy resin layer having a low thermal conductivity exists between each particle of the inorganic filler, and thus there was a limit to obtaining a high thermal conductivity in the metal base substrate.

As a method for improving the thermal conductivity of the metal base substrate described in PTL 1, for example, it is conceivable to attach a metal foil to one side of the metal base plate by using a thermally conductive insulating adhesive sheet (see, for example, PTL 2) that uses a ceramic resin composite, in which a sintered body having an integral structure in which non-oxide ceramic primary particles are three-dimensionally continuous is impregnated with a thermosetting resin composition. The thermally conductive insulating adhesive sheet forms a continuous network of non-oxide ceramics, so that the thermal conductivity can be further increased.

Citation List

Patent Literature

PTL 1: JP 2009-049062 A
PTL 2: WO 2017/155110 A

Summary of Invention

Technical Problem

Since a large current flows through the power module, it is preferable to increase the thickness of the metal foil to be attached to the metal base plate in order to suppress the generation of Joule heat in wirings formed on the surface of the metal base substrate. When forming a metal pattern by etching a thick metal foil attached to a metal base plate, it takes time to form the metal pattern, which increases the production cost of the metal base substrate. Therefore, from the viewpoint of the production cost of the metal base substrate, it is preferable to form a metal pattern on the surface of the metal base substrate by attaching a metal foil cut product obtained by cutting the metal foil to the metal base plate.

The thermally conductive insulating adhesive sheet described in PTL 2 has poor flexibility because it is based on a non-oxide ceramic porous body. Therefore, there has been a problem that, when the metal foil cut product is attached to the thermally conductive insulating adhesive sheet described in PTL 2 laminated on the metal base plate and pressurized, cracks occur in areas around the metal foil cut product in the thermally conductive insulating adhesive sheet.

Therefore, an object of the present invention is to provide a method of producing a circuit board capable of suppressing the occurrence of cracks in a semi-cured composite sheet that contains a porous ceramic and a semi-cured product of a thermosetting composition filling voids of the porous ceramic even when a metal foil cut product obtained by cutting a metal foil is attached to the semi-cured composite sheet and pressure is applied thereto, and a circuit board obtained by the production method.

Solution to Problem

As a result of intensive research by the inventors of the present invention, the inventors have found that, when attaching the metal foil cut product to the semi-cured composite sheet and pressurize the same, the occurrence of cracks in the semi-cured composite sheet can be suppressed by preventing the occurrence of a large deviation in a thickness direction at a boundary between an area where the metal foil cut product is arranged and an area where the metal foil cut product is not arranged in the semi-cured composite sheet, and thus have completed the present invention. The present invention has the following gist.

[1] A method of producing a circuit board by laminating a metal foil cut product obtained by cutting a metal foil on a semi-cured composite sheet that contains a porous ceramic and a semi-cured product of a thermosetting composition filling voids of the porous ceramic, the production method including a step of placing, on the semi-cured composite sheet, a plate-shaped member having an opening that fits with the metal foil cut product; a step of fitting the metal foil cut product into the opening of the plate-shaped member and placing the metal foil cut product on the semi-cured composite sheet on which the plate-shaped member has been placed; a step of pressurizing, while heating, the semi-cured composite sheet on which the plate-shaped member and the metal foil cut product have been placed to produce a first laminate; and a step of removing the plate-shaped member from the first laminate to produce a second laminate, wherein an absolute value of a difference between a thickness of the metal foil cut product and a thickness of the plate-shaped member is 0.25 mm or less (or 60% or less with respect to a thickness of the semi-cured composite sheet).
[2] The method of producing a circuit board according to [1] above, wherein the plate-shaped member includes a first plate-shaped member having an opening that fits with the metal foil cut product, and a second plate-shaped member, which has an opening that fits with the metal foil cut product and which is a release sheet that prevents adhesion between the first plate-shaped member and the semi-cured composite sheet.
[3] The method of producing a circuit board according to [1] or [2] above, wherein a material of the plate-shaped member or a material of the first plate-shaped member is the same as a material of the metal foil cut product.
[4] The method of producing a circuit board according to any one of [1] to [3] above, further including a step of placing the semi-cured composite sheet on a metal base plate, wherein the step of placing the plate-shaped member includes placing a plate-shaped member on the semi-cured composite sheet that has been placed on the metal base plate, and the step of placing the metal foil cut product includes placing the metal foil cut product on the semi-cured composite sheet that has been placed on the metal base plate.
[5] A circuit board production method of producing a circuit board by laminating a metal foil cut product obtained by cutting a metal foil on a semi-cured composite sheet that contains a porous ceramic and a semi-cured product of a thermosetting composition filling voids of the porous ceramic, the production method including a step of placing the metal foil cut product on the semi-cured composite sheet; and a step of producing a laminate by applying a pressure of 1.0 to 8.0 MPa while heating the semi-cured composite sheet on which the metal foil cut product has been placed.
[6] The method of producing a circuit board according to any one of [1] to [5] above, further including a step of heating and curing the first laminate, the second laminate, or the laminate.
[7] A circuit board including a cured composite layer containing a porous ceramic and a cured product of a thermosetting composition filling voids of the porous ceramic, and a metal pattern provided on a surface of the cured composite layer, wherein a value obtained by dividing a recess amount of a side surface of the metal pattern by a thickness of the metal pattern and a value obtained by dividing a spread amount of the side surface of the metal pattern by the thickness of the metal pattern are 0.055 or less, and the circuit board has a dielectric breakdown voltage of 3.5 kV or more.
[8] The circuit board according to [7] above, further including a metal base plate provided on a surface opposite to a surface of the cured composite layer on the metal pattern side.

Advantageous Effects of Invention

According to the present invention, it is possible to provide a method of producing a circuit board capable of suppressing the occurrence of cracks in a semi-cured composite sheet that contains a porous ceramic and a semi-cured product of a thermosetting composition filling the voids of the porous ceramic even when a metal foil cut product obtained by cutting a metal foil is attached to the semi-cured composite sheet and pressure is applied thereto, and a circuit board obtained by the production method.

Brief Description of Drawings

Fig. 1 is a schematic diagram for explaining members used in a method of producing a circuit board according to an embodiment of the present invention.
Fig. 2 (a) to (d) are schematic diagrams for explaining the method of producing a circuit board according to the embodiment of the present invention.
Fig. 3 (a) is a schematic diagram for explaining a recess amount of one side surface of a metal pattern, and Fig. 3 (b) is a schematic diagram for explaining a spread amount of the side surface of the metal pattern.
Fig. 4 is a schematic diagram for explaining members used in a modification of the method of producing a circuit board according to an embodiment of the present invention.
Fig. 5 (a) to (e) are schematic diagrams for explaining the modification of the method of producing a circuit board according to the embodiment of the present invention.

Description of Embodiments

[Method of Producing Circuit Board]

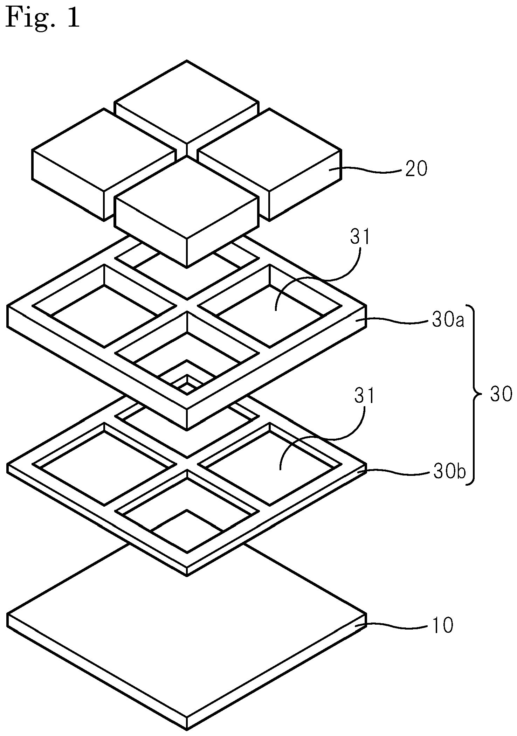

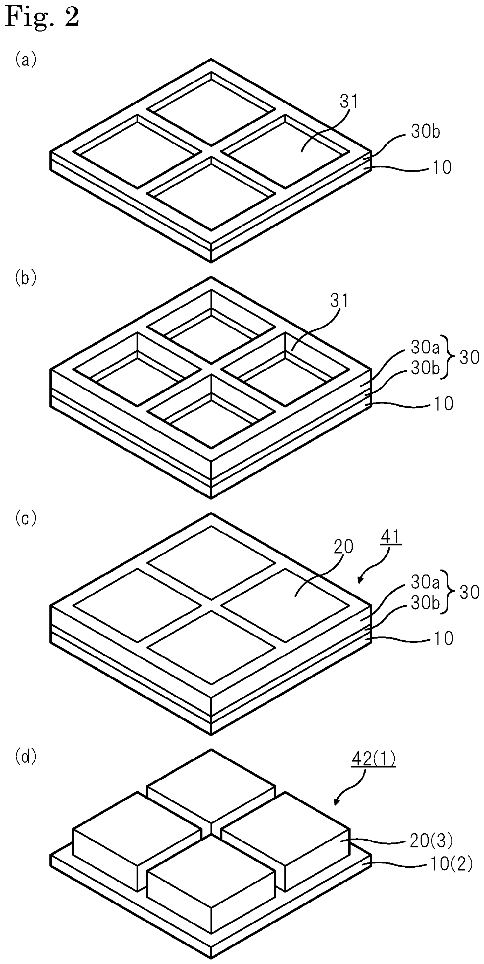

A method of producing a circuit board according to one embodiment of the present invention will be described with reference to Figs 1 and 2. Fig. 1 is a diagram for explaining members used in the method of producing a circuit board according to one embodiment of the present invention. Fig. 2 is a diagram for explaining the method of producing a circuit board according to one embodiment of the present invention.

The method of producing a circuit board according to one embodiment of the present invention produces a circuit board by laminating a metal foil cut product 20 obtained by cutting a metal foil on a semi-cured composite sheet 10 that contains a porous ceramic and a semi-cured product of a thermosetting composition filling the voids of the porous ceramic. The method of producing a circuit board according to one embodiment of the present invention includes a step (A) of placing, on the semi-cured composite sheet, a plate-shaped member 30 having an opening 31 that fits with the metal foil cut product 20, a step (B) of fitting the metal foil cut product 20 into the opening 31 of the plate-shaped member 30 and placing the metal foil cut product 20 on the semi-cured composite sheet 10 on which the plate-shaped member 30 has been placed, a step (C) of pressurizing, while heating, the semi-cured composite sheet 10 on which the plate-shaped member 30 and the metal foil cut product 20 have been placed to produce a first laminate 41, and a step (D) of removing the plate-shaped member 30 from the first laminate 41 to produce a second laminate 42. The absolute value of the difference between the thickness of the metal foil cut product 20 and the thickness of the plate-shaped member 30 is 0.25 mm or less. In this way, the occurrence of cracks in the semi-cured composite sheet 10 can be suppressed even when the metal foil cut product 20 obtained by cutting the metal foil is attached to the cured composite sheet 10 and a pressure is applied thereto. When cracks occur in the semi-cured composite sheet 10, the insulation of the circuit board may deteriorate.

(Step (A))

In the step (A), as shown in Figs. 2 (a) and (b), the plate-shaped member 30 (a first plate-shaped member 30a and a second plate-shaped member 30b) having the opening 31 that fits with the metal foil cut product 20 is placed on the semi-cured composite sheet 10.

<Semi-cured Composite Sheet>

The semi-cured composite sheet 10 includes a porous ceramic and a semi-cured product of a thermosetting composition that fills the voids of the porous ceramic. For example, the voids of the porous ceramic can be filled with the thermosetting composition by an impregnation method.

The porous ceramic has a structure in which a plurality of fine pores (hereinafter also referred to as "pores") are formed. At least a part of the pores in the porous ceramic may be connected to one another to form continuous pores.

The porous ceramic is preferably formed of a sintered body of an inorganic compound. The sintered body of an inorganic compound may be a sintered body of an insulator. The insulator in the sintered body of an insulator preferably contains a non-oxide, such as a carbide, a nitride, a diamond and a graphite, and more preferably contains a nitride. The carbide may be a silicon carbide or the like. The nitride may contain at least one nitride selected from the group consisting of a boron nitride, an aluminum nitride and a silicon nitride, and preferably contains a boron nitride. That is, the porous ceramic may preferably be formed of a sintered body of an insulator containing a boron nitride, and is more preferably be formed of a boron nitride sintered body. When the porous ceramic is formed of a boron nitride sintered body, the boron nitride sintered body may be formed by sintering together primary particles of a boron nitride. Any one of an amorphous boron nitride and a hexagonal boron nitride can be used as the boron nitride. Moreover, a boron nitride sintered body can also be obtained by firing a mixture of a boron-containing compound, such as boric acid, boron oxide, and borax, and a nitrogen-containing compound, such as urea and melamine, or by firing a hexagonal boron carbonitride ($h-B_4CN_4$).

The thermal conductivity of the inorganic compound forming the porous ceramic may be, for example, 30 W/(m·K) or more, 50 W/(m K) or more, or 60 W/(m·K) or more. When the porous ceramic is formed of an inorganic compound having excellent thermal conductivity, the heat resistance of a resulting semi-cured composite sheet can be reduced. The thermal conductivity of the inorganic compound is measured by a laser flash method on a sample in which the inorganic compound is formed into a size of length 10 mm × width 10 mm × thickness 2 mm.

The median pore diameter of the pores in the porous ceramic may be, for example, 0.5 pm or more, and from the viewpoint that the thermosetting composition can be suitably filled into the pores, the median pore diameter is preferably 0.6 pm or more, more preferably 0.8 pm or more, and still more preferably 1 pm or more. The average pore diameter of the pores is preferably 4.0 pm or less, 3.0 pm or less, 2.5 pm or less, 2.0 pm or less, or 1.5 pm or less, from the viewpoint of improving the insulation of the semi-cured composite sheet.

The median pore diameter of the pores in the porous ceramic is defined as the pore diameter at which a cumulative pore volume reaches 50% of the total pore volume in the pore diameter distribution (horizontal axis: pore diameter, vertical axis: cumulative pore volume) measured using a mercury porosimeter. As the mercury porosimeter, a mercury porosimeter manufactured by Shimadzu Corporation can be used, and the pressure is increased from 0.03 atmosphere to 4000 atmospheres for measurement.

The proportion of pores in the porous ceramic (porosity) is, based on the total volume of the porous body, preferably 10% by volume or more, 20% by volume or more, or 30% by volume or more from the viewpoint of suitably improving the strength of the semi-cured composite by filling with the thermosetting composition, and is preferably 70% by volume or less, more preferably 60% by volume or less, and still more preferably 50% by volume or less, from the viewpoint of improving the insulation and thermal conductivity of the semi-cured composite. The ratio (porosity) is calculated according to the following formula from a bulk density D1 ($g/cm^3$) obtained from the apparent volume and mass of the porous ceramic and a theoretical density D2 (for example, 2.28 $g/cm^3$ in the case of a boron nitride) of a material constituting the porous ceramic.

$$\text{Porosity (\% by volume)} = [1 - (D1/D2)] \times 100$$

The proportion of the porous ceramic in the semi-cured composite sheet is preferably 30% by volume or more, more preferably 40% by volume or more, and still more preferably 50% by volume or more, from the viewpoint of improving the insulation and thermal conductivity of the semi-cured composite sheet. The proportion of the porous ceramic in the semi-cured composite sheet may be, for example, 90% by volume or less, 80% by volume or less, 70% by volume or less, or 60% by volume or less.

The thermosetting composition is a composition containing a compound having thermosetting properties. The thermosetting composition contains, for example, an epoxy compound and a cyanate compound as compounds having thermosetting properties.

As the epoxy compound, a compound having a desired viscosity as a semi-cured product or a compound having a viscosity suitable for impregnation when impregnating porous ceramics can be used. Examples of the epoxy compound include 1,6-bis(2,3-epoxypropan-1-yloxy)naphthalene, a bisphenol A type epoxy resin, a bisphenol F type epoxy resin, and a dicyclopentadiene type epoxy resin. Of these, 1,6-bis(2,3-epoxypropan-1-yloxy)naphthalene is commercially available, for example, as HP-4032D (trade name, manufactured by DIC Corporation). In addition, as commercially available epoxy compounds, EP-4000L, EP4088L, EP3950 (all trade names, manufactured by ADEKA Corporation), EXA-850CRP (trade name, DIC Corporation), jER807, jER152, YX8000, and YX8800 (all trade names, manufactured by Mitsubishi Chemical Corporation) are used. A compound having a vinyl group can also be used as the epoxy compound. As an epoxy compound having a vinyl group, for example, TEPIC-FL, TEPIC-VL (all trade names, manufactured by Nissan Chemical Industries, Ltd.), MA-DGIC, DA-MGIC (all trade names, manufactured by Shikoku Kasei Co., Ltd.) are commercially available.

The content of the epoxy compound is, based on the total amount of the thermosetting composition, preferably 30% by mass or more, more preferably 40% by mass or more, and still more preferably 50% by mass or more, and is preferably 85% by mass or less, more preferably 75% by mass or less, and still more preferably 70% by mass or less.

Examples of the cyanate compound include dimethylmethylenebis(1,4-phenylene)biscyanate and bis(4-cyanatophenyl)methane. Dimethylmethylenebis(1,4-phenylene)biscyanate is commercially available, for example, as TA-CN (trade name, manufactured by Mitsubishi Gas Chemical Company, Inc.).

The content of the cyanate compound is, based on the total amount of the thermosetting composition, preferably 5% by mass or more, more preferably 8% by mass or more, and still more preferably 10% by mass or more, and is preferably 51% by mass or less, more preferably 40% by mass or less, and still more preferably 30% by mass or less.

From the viewpoint of maintaining the thermosetting composition in a semi-cured state with a desired viscosity (details will be described later), the equivalent ratio of the epoxy group of the epoxy compound to the cyanato group of the cyanate compound contained in the thermosetting composition (epoxy group equivalent/cyanato group equivalent) is 1.0 or more. The equivalent ratio is preferably 1.5 or more, more preferably 2.0 or more, and still more preferably 2.5 or more. Moreover, from the viewpoint of facilitating impregnation with the thermosetting composition and from the viewpoint of improving the heat resistance of the semi-cured composite, the equivalent ratio is preferably 6.0 or less, 5.5 or less, 5.0 or less, 4.5 or less, 4.0 or less, 3.5 or less, or 3.0 or less.

The thermosetting composition may further contain other compounds having thermosetting properties other than the epoxy compound and the cyanate compound.

The thermosetting composition may further contain a curing agent in addition to the epoxy compound and the cyanate compound from the viewpoint of making it easier to maintain the semi-cured state with a desired viscosity. In one embodiment, the thermosetting composition contains a curing agent of an epoxy compound. The curing agent of an epoxy compound is a compound that forms a crosslinked structure with an epoxy compound.

The curing agent of an epoxy compound preferably contains at least one selected from the group consisting of a benzoxazine compound, an ester compound, and a phenol compound.

Examples of the benzoxazine compound include a bisphenol F type benzoxazine compound. The bisphenol F type benzoxazine compound is commercially available, for example, as F-a type benzoxazine (trade name, manufactured by Shikoku Kasei Kogyo Co., Ltd.).

Examples of the ester compound include diphenyl phthalate and benzyl 2-ethylhexyl phthalate. The ester compound may be an active ester compound. An active ester compound refers to a compound having one or more ester bonds in a structure thereof and having aromatic rings bonded to both sides of the ester bond.

Examples of the phenol compound include a phenol, cresol, bisphenol A, bisphenol F, phenol novolak resin, a cresol novolak resin, a dicyclopentadiene-modified phenol resin, a terpene-modified phenol resin, a triphenolmethane type resin, a phenol aralkyl resin (having a phenylene skeleton, a biphenylene skeleton etc.), a naphthol aralkyl resin, and an allylphenol resin. These may be used alone or in combination of two or more thereof. The phenol compound is commercially available as, for example, TD2131, VH4150 (trade names, manufactured by DIC Corporation), MEHC-7851M, MEHC-7500, MEH8005, and MEH8000H (trade names, manufactured by Meiwa Kasei Co., Ltd.).

When the thermosetting composition contains a curing agent of an epoxy compound, the content of the curing agent is, based on the total amount of the thermosetting composition, preferably 0.1% by mass or more, more preferably 5% by mass or more, and still more preferably 7% by mass or more, and is preferably 30% by mass or less, more preferably 20% by mass or less, and still more preferably 15% by mass or less.

The thermosetting composition may further contain a curing accelerator in addition to the compounds described above. The curing accelerator contains a component (catalytic curing agent) that functions as a curing reaction catalyst. By containing the curing accelerator in the thermosetting composition, the reaction between the epoxy compound and the cyanate compound, a self-polymerization reaction of the epoxy compound, and/or the reaction between the epoxy compound and a curing agent of the epoxy compound, which will be described later, can be facilitated, and the semi-cured product can be easily maintained in a semi-cured state with a desired viscosity. Examples of the component include an organic metal salt, a phosphorus compound, an imidazole derivative, an amine compound, and a cationic polymerization initiator. These curing agents may be used alone or in combination of two or more kinds thereof.

Examples of the organic metal salt include bis(2,4-pentanedionato) zinc (II), zinc octylate, zinc naphthenate, cobalt naphthenate, copper naphthenate, iron acetylacetonate, nickel octylate, manganese octylate, and other organic metal salts.

Examples of the phosphorus compound include tetraphenylphosphonium tetra-p-tolylborate, tetraphenylphosphonium tetraphenylborate, triphenylphosphine, tri-p-tolylphosphine, tris(4-chlorophenyl)phosphine, tris(2,6-dimethoxyphenyl)phosphine, triphenylphosphine triphenylborane, tetraphenylphosphonium dicyanamide, and tetraphenylphosphonium tetra(4-methylphenyl)borate.

Examples of the imidazole derivative include 1-(1-cyanomethyl)-2-ethyl-4-methyl-1H-imidazole, 2-ethyl-4-methylimidazole, 2-methylimidazole, 2-phenylimidazole, 1-cyanoethyl-2-phenylimidazole, 2-phenyl-4,5-dihydroxymethylimidazole, 2-phenyl-4-methyl-5-hydroxymethylimidazole, and 2,4,5-triphenylimidazole.

Examples of the amine compound include dicyandiamide, triethylamine, tributylamine, tri-n-octylamine, 1,4-diazabicyclo[2.2.2]octane, 1,8-diazabicyclo[5.4.0]undec-7-ene, benzyldimethylamine, 4-methyl-N,N-dimethylbenzylamine, 2,4,6-tris(dimethylaminomethyl)phenol, and 4-dimethylaminopyridine.

Examples of the cationic polymerization initiator include a benzylsulfonium salt, a benzylammonium salt, a benzylpyridinium salt, a benzylphosphonium salt, a hydrazinium salt, a carboxylic acid ester compound, a sulfonic acid ester compound, an amine imide, an antimony pentachloride-acetyl chloride complex, and a diaryliodonium salt-dibenzyloxy copper.

The content of the curing accelerator described above may be, with respect to a total of 100 parts by mass of the epoxy compound, the cyanate compound, and optionally the curing agent of the epoxy compound, 0.001 parts by mass or more, 0.01 parts by mass or more, or 0.05 parts by mass or more, and may be 1 part by mass or less, 0.8 parts by mass or less, 0.5 parts by mass or less, 0.3 parts by mass or less, or 0.1 parts by mass or less. By setting the content within the range, a desired viscosity of the semi-cured product can be easily maintained.

The semi-cured composite contains a semi-cured product of the thermosetting composition described above. A semi-cured product of a thermosetting composition (also simply referred to as a "semi-cured product") refers to a cured product in which the curing reaction of the thermosetting composition has partially progressed. In one embodiment, the semi-cured product contains a reaction product (cured product) of an epoxy compound and a cyanate compound, and an uncured epoxy compound. The semi-cured product may partially contain an uncured cyanate compound, and may also partially contain a cured product of an epoxy compound (for example, a cured product obtained by curing an epoxy compound by self-polymerization reaction).

Whether a semi-cured product is contained in the semi-cured composite can be checked by measuring the adhesive strength of the semi-cured composite measured by the following method. First, the semi-cured composite is formed into a sheet by a method to be described later, and the sheet is placed between two copper plates, heated and pressurized under conditions of 200°C and 10 MPa for 5 minutes, and further heated under conditions of 200°C and atmospheric pressure for 2 hours to obtain a laminate. Next, according to JIS K 6854-1: 1999 "Adhesive-Determination of peel strength of bonded assemblies", a 90° peel test is performed to measure the area of a cohesive failure portion. As a result, if the area of the cohesive failure portion is 30 area% or more, it can be said that a semi-cured product is contained in the semi-cured composite.

Next, a method of producing a semi-cured composite sheet will be described. For example, the method of producing a semi-cured composite sheet includes a step of impregnating a porous body with a thermosetting composition containing an epoxy compound and a cyanate compound (impregnation step), a step of heating the porous body that has been impregnated with the thermosetting composition at a temperature T1 at which the cyanate compound reacts (semi-curing step), and a step of slicing the porous body impregnated with the thermosetting composition (sheet forming step). However, it is also fine to impregnate a porous body that has formed into a sheet in advance with the thermosetting composition without going through the step of slicing the porous body.

In the impregnation step, in one embodiment, first, the porous body described above is prepared. The porous body may be produced by sintering raw materials, or a commercially available product may be used. When the porous body is a sintered body of an inorganic compound, the porous body can be obtained by sintering a powder containing the inorganic compound. That is, in one embodiment, the impregnation step includes a step of sintering a powder containing an inorganic compound (hereinafter also referred to as an inorganic compound powder) to obtain a sintered body of the inorganic compound, which is a porous body.

The sintered body of the inorganic compound may be prepared by subjecting a slurry containing the powder of the inorganic compound to a spheroidization treatment using a spray dryer or the like, and sintering after further molding to prepare a sintered body that is a porous body. For molding, a mold press molding method may be used, or a cold isostatic pressing (CIP) method may be used.

A sintering aid may be used during sintering. The sintering aid may be, for example, yttria oxide, oxides of rare earth elements such as alumina oxide and magnesium oxide, alkali metal carbonates such as lithium carbonate and sodium carbonate, and boric acid. When a sintering aid is blended, the amount of the sintering aid added may be, for example, 0.01 parts by mass or more, or 0.1 parts by mass or more, with respect to a total of 100 parts by mass of the inorganic compound and the sintering aid. The amount of the sintering aid added may be 20 parts by mass or less, 15 parts by mass or less, or 10 parts by mass or less, with respect to a total of 100 parts by mass of the inorganic compound and the sintering aid. By setting the addition amount of the sintering aid within the above range, it becomes easy to adjust the average pore diameter of the sintered body within the above range.

The sintering temperature of the inorganic compound may be, for example, 1600°C or higher or 1700°C or higher. The sintering temperature of a nitride may be, for example, 2200°C or lower, or 2000°C or lower. The sintering time of the inorganic compound may be, for example, 1 hour or more, and may be 30 hours or less. The atmosphere during sintering may be, for example, an inert gas atmosphere such as nitrogen, helium, and argon.

For sintering, for example, a batch type furnace and a continuous type furnace can be used. Examples of the batch type furnace include muffle furnaces, tubular furnaces, and atmosphere furnaces. Examples of the continuous type furnace include rotary kilns, screw conveyor furnaces, tunnel furnaces, belt furnaces, pusher furnaces, and koto-shaped continuous furnaces.

In the impregnation step, subsequently, a solution containing the thermosetting composition is prepared in an impregnation apparatus, and the pores of the porous body are impregnated with the thermosetting composition by immersing the porous body in the solution or applying the solution containing the thermosetting composition to the porous body in an air atmosphere.

The impregnation step may be performed under an atmospheric condition, under a reduced pressure condition, or under a pressurized condition, or may be performed by combining impregnation under a reduced pressure condition and impregnation under a pressurized condition. The pressure in the impregnation apparatus in the case of performing the impregnation step under a reduced pressure condition may be, for example, 1000 Pa or less, 500 Pa or less, 100 Pa or less, 50 Pa or less, or 20 Pa or less. The pressure in the impregnation apparatus in the case of performing the impregnation step under a pressurized condition may be, for example, 1 MPa or more, 3 MPa or more, 10 MPa or more, or 30 MPa or more.

When impregnating the thermosetting composition into the porous body, the thermosetting composition may be heated. By heating the thermosetting composition, the viscosity of the solution is adjusted and impregnation into the porous body is promoted. The temperature at which the thermosetting composition is heated for impregnation may be higher than the temperature T1 to be described later. In this case, the temperature at which the thermosetting composition is heated for impregnation may be lower than a temperature T2 in a curing step to be described later. The upper limit of the temperature at which the thermosetting composition is heated may be a temperature equal to or lower than the temperature T1 + 20°C.

In the impregnation step, the porous body is immersed in or coated with the solution containing the thermosetting composition and held for a predetermined time. The predetermined time (immersion time) is not particularly limited, and may be, for example, 5 minutes or longer, 30 minutes or longer, 1 hour or longer, 5 hours or longer, 10 hours or longer, 100 hours or longer, or 150 hours or longer.

In the semi-curing step, the porous body impregnated with the thermosetting composition is heated at the temperature T1 at which the cyanate compound reacts. As a result, the cyanate compound contained in the thermosetting composition reacts to obtain a semi-cured product. At this time, the cyanate compounds may react with each other, or the cyanate compound and a part of the epoxy compound may react. On the other hand, in the thermosetting composition, as described above, the equivalent ratio of the epoxy group of the epoxy compound to the cyanato group of the cyanate compound is 1.0 or more. That is, in the semi-cured product, the epoxy compound is contained in excess of the cyanate compound in terms of epoxy equivalent, and these epoxy compounds remain in an uncured state. As a result, a semi-cured product of the thermosetting composition is obtained.

From the viewpoint of sufficiently impregnating the semi-cured product into the porous body, the temperature T1 is preferably 70°C or higher, more preferably 80°C or higher, and still more preferably 90°C or higher. From the viewpoint of reducing the change in viscosity over time, the temperature T1 is preferably 180°C or lower, more preferably 150°C or lower, and still more preferably 120°C or lower. The temperature T1 refers to an atmospheric temperature at the time of heating the porous body that has been impregnated with the thermosetting composition.

The heating time in the semi-curing step may be 1 hour or more, 3 hours or more, or 5 hours or more, and may be 12 hours or less, 10 hours or less, or 8 hours or less.

Since the above-mentioned semi-cured composite contains some uncured compounds (mainly epoxy compounds), the adhesion to an adherend is more excellent than that of a cured product in which the thermosetting composition is fully cured. In addition, in the semi-cured composite, the uncured state is maintained for a long time unless heated at a temperature at which an uncured compound cures (details will be described later), and thus a desired viscosity with excellent adhesion to the adherend can be easily maintained. As a result, a semi-cured composite having excellent handleability can be obtained.

In the sheet forming step, for example, a wire saw is used to slice the porous body impregnated with the thermosetting composition. In this way, a semi-cured composite sheet having a desired thickness can be obtained. A cured composite sheet may be obtained by slicing the porous body before being impregnated with the thermosetting composition to prepare a sheet-shaped porous body, and impregnating the sheet-shaped porous body with the thermosetting composition. In addition, a cured composite sheet may be obtained by molding and sintering the porous body into a sheet shape at the stage of producing the porous body, and impregnating the sheet-shaped porous body with the thermosetting composition.

<Plate-shaped Member>

The plate-shaped member 30 has the opening 31 that fits with the metal foil cut product 20, as shown in Fig. 1. As shown in Fig. 1, the plate-shaped member 30 preferably includes the first plate-shaped member 30a having the opening 31 that fits with the metal foil cut product 20, and the second plate-shaped member 30b, which has the opening 31 that fits with the metal foil cut product 20 and which is a release sheet that prevents adhesion between the first plate-shaped member 30a and the semi-cured composite sheet 10. In this case, the thickness of the plate-shaped member 30 is a total thickness of the thickness of the first plate-shaped member 30a and the thickness of the second plate-shaped member 30b. In this case, in the step (A), as shown in Fig. 2 (a), the second plate-shaped member 30b is placed on the semi-cured composite sheet 10, and then, as shown in Fig. 2 (b), the first plate-shaped member 30a is placed on the second plate-shaped member 30b.

Examples of materials constituting the first plate-shaped member 30a include metals, such as copper, aluminum, iron, nickel, and magnesium, and alloys thereof, plastics, such as polyamide, polyimide, polyacetal, polycarbonate, polyphenylene sulfide, and polytetrafluoroethylene, and ceramics, such as aluminum nitride and silicon nitride. As will be described later, after fitting the metal foil cut product 20 into the opening of the plate-shaped member 30a, the first plate-shaped member 30a and the metal foil cut product 20 are heated. Therefore, the coefficient of thermal expansion of the first plate-shaped member 30a is preferably close to or the same as the coefficient of thermal expansion of the metal foil cut product 20. From this point of view, of these materials, the material constituting the first plate-shaped member 30a is preferably the same as the material constituting the metal foil cut product 20.

The second plate-shaped member 30b is not particularly limited as long as it is a plate-shaped or sheet-shaped member that is releasable from the semi-cured composite sheet 10. From the viewpoint of releasability from the semi-cured composite sheet 10 and heat resistance, the second plate-shaped member 30b is preferably a fluororesin sheet and a silicone resin, and more preferably a fluororesin. The second plate-shaped member 30b may be a plastic sheet, such as polyethylene terephthalate, polypropylene, and polyethylene, which has been subjected to a release treatment using a release agent, such as a silicone release agent, an alkyl pendant release agent, and a condensed wax release agent.

Also, the plate-shaped member 30 may consist of only the first plate-shaped member 30a. In this case, the first plate-shaped member 30a is preferably formed of a material that is releasable from the semi-cured composite sheet 10. For example, the first plate-shaped member 30a may be a plate-shaped member consisting of a fluororesin or a silicone resin. Alternatively, the surface of the first plate-shaped member 30a may be subjected to a release treatment using a release agent so that the first plate-shaped member 30a has releasability from the semi-cured composite sheet 10. Further, a layer of a material having releasability from the semi-cured composite sheet 10, such as a fluororesin and a silicone resin, may be formed on the surface of the first plate-shaped member 30a.

The openings 31 of the first plate-shaped member 30a and the second plate-shaped member 30b can be formed by a normal cutting method. Examples of the cutting method include a removal cutting processing method, such as a cutting processing method, an abrasive processing method, a water jet processing method, a fusion cutting method, a laser processing method, an electron beam processing method, and an electric discharge processing methods, and a destructive cutting processing method, such as a shearing method and a knife blade cutting method. Of these cutting methods, the destructive cutting processing method is preferable from the viewpoint of cutting efficiency, and the shearing method is more preferable from the viewpoint of controlling the cutting contour and cut surface properties. In this case, what is removed becomes scrap and a hole side becomes a product, and thus the shearing method in this case is a punching (piercing) method. Since a mold is necessary in the shearing method, the openings 31 of the first plate-shaped member 30a and the second plate-shaped member 30b may be formed by a removal cutting processing method at a prototype stage.

(Step (B))

In the step (B), as shown in Fig. 2 (c), the metal foil cut product 20 is placed on the semi-cured composite sheet 10 on which the plate-shaped member 30 is placed by fitting the metal foil cut product 20 into the opening 31 of the plate-shaped member 30. As a result, the metal foil cut product 20 can be precisely arranged at an intended position.

<Metal Foil Cut Product>

The metal foil cut product 20 is a product obtained by cutting a metal foil, and has the same contour as that of a part or all of a metal pattern 3 formed on the surface of a circuit board 1, as shown in Fig. 1 and Fig. 2 (d). Examples of materials constituting the metal foil cut product 20 include copper, aluminum, nickel, iron, tin, gold, silver, molybdenum, titanium, and stainless steel. These metals can be used alone by one kind or in combination of two or more kinds thereof. Of these metals, copper and aluminum are preferred, and copper is more preferred, from the viewpoint of electrical conductivity and cost.

As described above, the metal foil cut product 20 is obtained by cutting a metal foil. The method of cutting the metal foil to obtain the metal foil cut product 20 is not particularly limited as long as the metal foil can be cut. Examples of the method of cutting the metal foil to obtain the metal foil cut product 20 include a removal cutting processing method, such as a cutting processing method, an abrasive processing method, a water jet processing method, a fusion cutting method, a laser processing method, an electron beam processing method, and an electric discharge processing methods, and a destructive cutting processing method, such as a shearing method and a knife blade cutting method. Of these cutting methods, the destructive cutting processing method is preferable from the viewpoint of cutting efficiency, and the shearing method is more preferable from the viewpoint of controlling the cutting contour and cut surface properties.

From the viewpoint of suppressing Joule heat generation of the metal pattern 3 formed on the surface of the circuit board 1, the thickness of the metal foil cut product 20 is preferably 0.3 mm or more, more preferably 0.5 mm or more, and still more preferably 1.0 mm or more. From the viewpoint of downsizing a power module, the thickness of the metal foil cut product 20 is preferably 5.0 mm or less, more preferably 4.0 mm or less, and still more preferably 3.0 mm or less.

(Step (C))

In the step (C), the semi-cured composite sheet 10 on which the plate-shaped member 30 (30a, 30b) and the metal foil cut product 20 have been placed is heated and pressurized to produce the first laminate 41 (see Fig. 2 (c)). At this time, the plate-shaped member 30 (30a, 30b) allows, even in a region of the semi-cured composite sheet 10 where the metal foil cut product 20 is not arranged, pressure to be applied in the same manner as in a region of the semi-cured composite sheet 10 where the metal foil cut product 20 is arranged. In this way, it is possible to suppress the occurrence of a deviation in a thickness direction at the boundary between the region where the metal foil cut product 20 is arranged and the region where the metal foil cut product 20 is not arranged in the semi-cured composite sheet 10. As a result, the occurrence of cracks in the semi-cured composite sheet 10 can be suppressed.

The absolute value of the difference between the thickness of the metal foil cut product 20 and the thickness of the plate-shaped member 30 (total thickness of the thickness of the first plate-shaped member 30a and the thickness of the second plate-shaped member 30b) is 0.25 mm or less. When the absolute value of the difference between the thickness of the metal foil cut product 20 and the thickness of the plate-shaped member 30 is greater than 0.25 mm, a large deviation in the thickness direction occurs at the boundary between the region where the metal foil cut product 20 is arranged and the region where the metal foil cut product 20 is not arranged in the semi-cured composite sheet 10 in the step (C). As a result, cracks occur in the semi-cured composite sheet 10. From the viewpoint of suppressing the occurrence of cracks in the semi-cured composite sheet 10, the absolute value of the difference between the thickness of the metal foil cut product 20 and the thickness of the plate-shaped member 30 (total thickness of the thickness of the first plate-shaped member 30a and the thickness of the second plate-shaped member 30b) is preferably 0.25 mm or less, more preferably 0.10 mm or less, and still more preferably 0 mm. In addition, from the viewpoint of suppressing the occurrence of cracks in the semi-cured composite sheet 10, the absolute value of the difference between the thickness of the metal foil cut product 20 and the thickness of the plate-shaped member 30 may preferably be 60% or less, more preferably 30% or less, and still more preferably 10% or less, of the thickness of the semi-cured composite sheet 10.

As for the pressurizing conditions in the step (C), the heating temperature is preferably 160 to 250°C, and more preferably 180 to 200°C; the pressure is preferably 3.0 to 25.0 MPa, and more preferably 5.0 to 25.0 MPa; and the pressurization time is preferably 3 minutes to 3 hours, and more preferably 5 minutes to 1 hour. In particular, by setting the pressure to 10 to 20 MPa, a circuit board having extremely high adhesion and high insulation can be produced.

(Step (D))

In the step (D), as shown in Fig. 2 (d), the plate-shaped member 30 (30a, 30b) is removed from the first laminate 41 to produce the second laminate 42. As a result, it is possible to obtain the circuit board 1 including a cured composite layer 2 containing a porous ceramic and a cured product of a thermosetting composition filling voids of the porous ceramic, and the metal pattern 3 provided on a surface of the cured composite layer 2, wherein a value obtained by dividing a recess amount of a side surface of the metal pattern 3 by the thickness of the metal pattern 3 and a value obtained by dividing a spread amount of the side surface of the metal pattern 3 by the thickness of the metal pattern 3 are 0.055 or less.

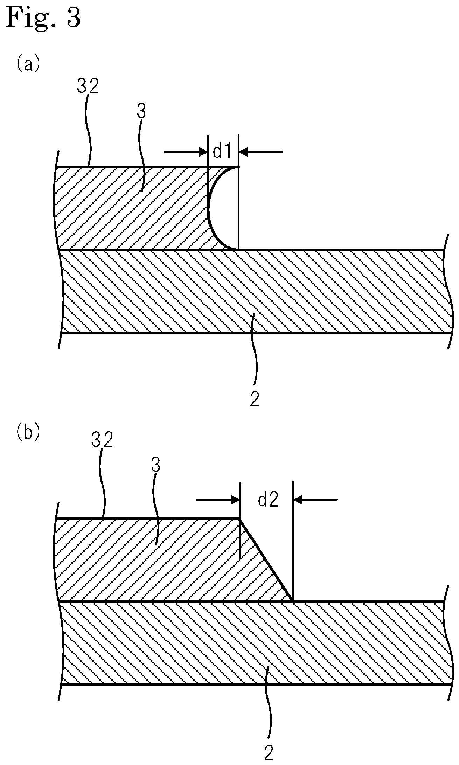

As shown in Fig. 3 (a), the recess amount of the side surface of the metal pattern 3 is a depth (d1) of the portion of the side surface of the metal pattern 3 that is most recessed inside the metal pattern 3 based on an edge of a surface 32 opposite to the surface of the metal pattern 3 on the side of the cured composite layer. On the other hand, as shown in Fig. 3 (b), the spread amount of the side surface of the metal pattern 3 is a spread amount (d2) of the portion of the side surface of the metal pattern 3 that spreads the most outside of the metal pattern 3 based on the edge of the surface 32 opposite to the surface of the metal pattern 3 on the side of the cured composite layer.

When the metal pattern 3 is formed by etching, the etching progresses not only in the thickness direction of the metal pattern 3, but also in an unintended lateral direction. Therefore, in general, at least one of the value obtained by dividing the recess amount (d1) of the side surface of the metal pattern 3 by the thickness of the metal pattern 3 and the value obtained by dividing the spread amount (d2) of the side surface of the metal pattern 3 by the thickness of the metal pattern 3 is greater than 0.055. On the other hand, in the circuit board 1 produced by the method of producing a circuit board according to one embodiment of the present invention, the metal pattern 3 is formed by a cutting method, particularly by a shearing method, and thus the properties of the cut surface, which is a side surface of the metal pattern, can be precisely controlled. As a result, the value obtained by dividing the recess amount of the side surface of the metal pattern 3 by the thickness of the metal pattern 3 and the value obtained by dividing the spread amount of the side surface of the metal pattern 3 by the thickness of the metal pattern 3 can be made 0.055 or less, preferably 0.04 or less, more preferably 0.02 or less, and still more preferably 0.01 or less. The lower limit of the aforementioned value range is, for example, 0.00.

Since the side surface of the metal pattern formed by etching is a side surface formed by removing the metal foil, the side surface becomes a removal processing surface. Therefore, when the side surface of the metal pattern 3 of the circuit board 1 is a side surface formed by the destructive cutting method, the side surface becomes a destructive surface, and it differs from the side surface of the metal pattern formed by etching in terms of the structure of the side surface. In particular, when the side surface of the metal pattern 3 of the circuit board 1 is a side surface obtained by shearing a metal foil, the side surface includes a sheared surface and a fractured surface. The sheared surface is a surface that has received a large amount of shear strain due to the biting of a tool, and is a glossy smooth portion that has been burnished by a side surface of the tool. On the other hand, the fractured surface is a portion where a crack is generated and fractured, and thus it is a portion where a crystal grain surface appears and that has fine unevenness. Such sheared surfaces and fractured surfaces do not appear on side surfaces of a metal pattern formed by etching.

From the viewpoint of suppressing Joule heat generation of the metal pattern 3 formed on the surface of the circuit board 1, the thickness of the metal pattern 3 is preferably 0.3 mm or more, more preferably 0.5 mm or more, and still more preferably 1.0 mm or more. From the viewpoint of downsizing the power module, the thickness of the metal pattern 3 is preferably 5.0 mm or less, more preferably 4.0 mm or less, and still more preferably 3.0 mm or less.

(Variations of Method of Producing Circuit Board)

The method of producing a circuit board according to one embodiment of the present invention can be modified as follows.

<Variation 1>

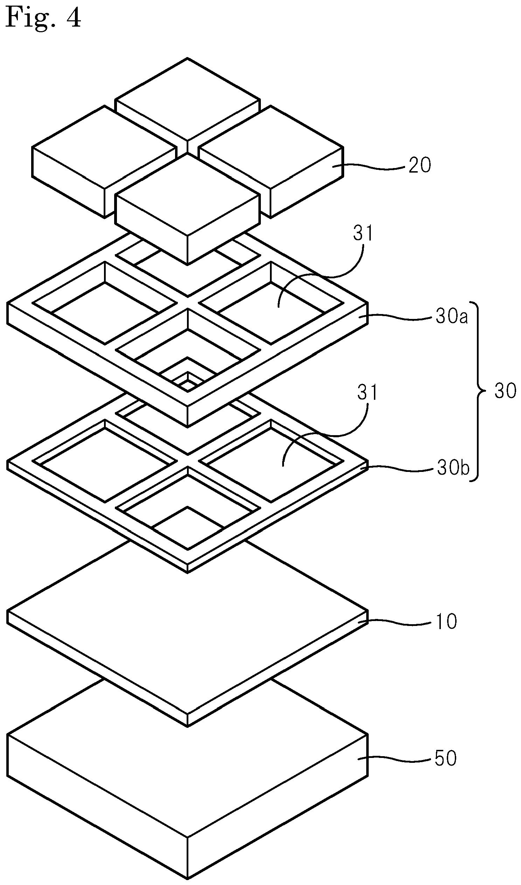

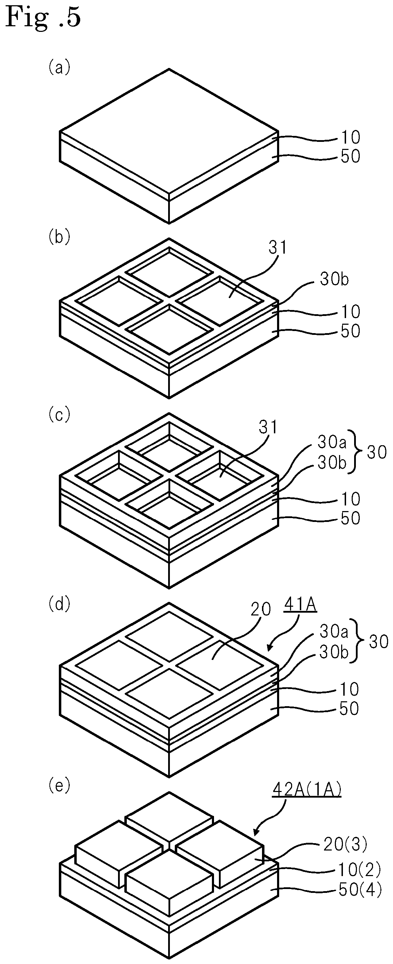

As shown in Fig. 4, a metal base plate 50 may further be used in a variation of the method of producing a circuit board according to one embodiment of the present invention. As a result, a circuit board 1A (see Fig. 5 (e)) further includes a metal base plate 4 provided on a surface opposite to the surface of the cured composite layer on the metal pattern side. In this way, the strength and heat dissipation of the circuit board 1A are improved. The variation of the method of producing a circuit board according to one embodiment of the present invention further includes a step of placing the semi-cured composite sheet 10 on the metal base plate 50 (see Fig. 5 (a)). As a result, in the step (A), the plate-shaped member 30 (30a, 30b) is placed on the semi-cured composite sheet 10 that has been placed on the metal base plate 50 (see Figs. 5 (b) and 5 (c)); in the step (B), the metal foil cut product 20 is placed on the semi-cured composite sheet 10 that has been placed on the metal base plate 50 (see Fig. 5 (d)); in the step (C), the semi-cured composite sheet 10, which has been placed on the metal base plate 50 and on which the plate-shaped member 30 (30a, 30b) and the metal foil cut product 20 have been placed, is heated and pressurized to produce a first laminate 41A (see Fig. 5 (d)); and in the step (D), the plate-shaped member 30 (30a, 30b) is removed from the first laminate 41A to produce a second laminate 42A (see Fig. 5 (e)).

Examples of materials constituting the metal base plate 50 include copper, aluminum, nickel, iron, tin, gold, silver, molybdenum, titanium, and stainless steel. These metals can be used alone by one kind or in combination of two or more kinds thereof. Of these metals, copper and aluminum are preferred from the viewpoint of thermal conductivity and cost. Moreover, the metal base plate is not limited to a plate shape, and may be processed into a fin or pin shape.

From the viewpoint of improving the strength of the circuit board 1A, the thickness of the metal base plate 50 is preferably 0.3 mm or more, more preferably 1.0 mm or more, and still more preferably 3.0 mm or more. From the viewpoint of downsizing the power module, the thickness of the metal base plate 50 is preferably 50.0 mm or less, more preferably 30.0 mm or less, and still more preferably 15.0 mm or less.

<Variation 2>

A variation of the method of producing a circuit board according to one embodiment of the present invention may further include a step of heating and curing the first laminate 41 or the second laminate 42. In this way, the semi-cured product in the semi-cured composite sheet 10 can be cured more reliably. The heating temperature in the step is preferably 130 to 250°C, more preferably 150 to 200°C, and the heating time is preferably 5 minutes to 24 hours, more preferably 60 minutes to 5 hours. The heating temperature may be raised continuously at a constant temperature raising rate or may be raised stepwise to the above heating temperature. For example, in the case of increasing the heating temperature stepwise to a heating temperature of 250°C, the temperature may be increased to a heating temperature of 150°C at a predetermined temperature raising rate and then maintained at the heating temperature of 150°C for 6 hours, increased from the heating temperature of 150°C to a heating temperature of 180°C at a predetermined temperature raising rate and then maintained at the heating temperature of 180°C for 4 hours, increased from the heating temperature of 180°C to a heating temperature of 200°C at a predetermined temperature raising rate and then maintained at the heating temperature of 200°C for 4 hours, and increased from the heating temperature of 200°C to a heating temperature of 250°C at a predetermined temperature raising rate and then maintained at the heating temperature of 250°C for 4 hours. In addition, the first laminate 41 or the second laminate 42 may be heated while applying a pressure of 0.1 to 25 MPa thereto.

<Variation 3>

As a method of preventing the occurrence of a large deviation in the thickness direction at the boundary between the region where the metal foil cut product is arranged and the region where the metal foil cut product is not arranged in the semi-cured composite sheet at the time of attaching the metal foil cut product to the semi-cured composite sheet and pressurizing, a method of setting the pressurizing condition in the step (C) to 1.0 to 8.0 MPa without using a plate-shaped member may also be used. From this point of view, the pressurizing condition in the step (C) is preferably 2.0 to 7.0 MPa, and more preferably 3.0 to 6.0 MPa.

The method of producing a circuit board according to one embodiment of the present invention and variations thereof are merely examples of the method of producing a circuit board of the present invention. Therefore, the method of producing a circuit board of the present invention is not limited to the method of producing a circuit board according to one embodiment of the present invention and variations thereof.

[Circuit Board]

The circuit board 1 according to one embodiment of the present invention will be described below with reference to Figs. 2 (d) and 3. The circuit board 1 according to one embodiment of the present invention includes the cured composite layer 2 containing a porous ceramic and a cured product of a thermosetting composition filling voids of the porous ceramic, and the metal pattern 3 provided on a surface of the cured composite layer 2. A value obtained by dividing the recess amount (d1) of a side surface of the metal pattern 3 by the thickness of the metal pattern 3 and a value obtained by dividing the spread amount (d2) of the side surface of the metal pattern 3 by the thickness of the metal pattern 3 are 0.055 or less. As a result, the area occupied by the metal pattern is reduced and the circuit board can be downsized. In addition, more precise control of the metal pattern 3 becomes possible. From this point of view, the value obtained by dividing the recess amount (d1) of the side surface of the metal pattern 3 by the thickness of the metal pattern 3 and the value obtained by dividing the spread amount (d2) of the side surface of the metal pattern 3 by the thickness of the metal pattern 3 are preferably 0.04 or less, more preferably 0.02 or less, and still more preferably 0.01 or less. The lower limit of the above value range is, for example, 0.00.

In addition, since the cured composite layer 2 and the metal pattern 3 of the circuit board 1 are the same as those described in Method of Producing Circuit Board according to one embodiment of the present invention above, description of the cured composite layer 2 and the metal pattern 3 of the circuit board 1 is omitted.

(Insulation)

The circuit board of one embodiment of the present invention has excellent insulation because cracks do not occur or occur very little. Specifically, the dielectric breakdown voltage measured by the method described in Examples is 3.5 kV or more. When the dielectric breakdown voltage is less than 3.5 kV, the voltage resistance of the circuit board may be insufficient for use in power modules. From this point of view, the dielectric breakdown voltage of the circuit board according to one embodiment of the present invention is preferably 4.5 kV or more. Although the upper limit of the range of the dielectric breakdown voltage of the circuit board according to one embodiment of the present invention is not particularly limited, it is, for example, 10 kV.

(Adhesion)

The circuit board of one embodiment of the present invention has good adhesion. Specifically, a black portion area ratio measured by the method described in Examples is preferably 90 area% or more. In particular, according to the method of producing a circuit board according to one embodiment of the present invention using a plate-shaped member, the circuit board according to one embodiment of the present invention can achieve high adhesion of 96 area% or more.

(Variation of Circuit Board)

The circuit board 1 according to one embodiment of the present invention can be modified as follows.

As shown in Fig. 5 (e), the circuit board 1A of one embodiment of the present invention may further include the metal base plate 4 provided on a surface opposite to the surface of the cured composite layer 2 on the side of the metal pattern 3. In this way, the strength and heat dissipation of the circuit board 1A are improved. The metal base plate 4 of the circuit board 1A is the same as that described in Variation of Method of Producing Circuit Board according to one embodiment of the present invention, and thus the description of the metal base plate 4 is omitted.

The circuit board of one embodiment of the present invention and variations thereof are merely examples of the circuit board of the present invention. Therefore, the circuit board of the present invention is not limited to the circuit board of one embodiment of the present invention and variations thereof. Examples

The present invention will be described in detail below with reference to examples. The present invention is not limited to the following examples.

[Fabrication of Porous Boron Nitride Sheet in Which Voids are Filled with Semi-cured Thermosetting Composition]

(Preparation of Boron Nitride Porous Body)

In a container, 40.0% by mass of an amorphous boron nitride powder (manufactured by Denka Co., Ltd., oxygen content: 1.5%, boron nitride purity: 97.6%, average particle size: 6.0 pm) and 60.0% by mass of a hexagonal boron nitride powder (manufactured by Denka Co., Ltd., oxygen content: 0.3%, boron nitride purity: 99.0%, average particle size: 30.0 pm) were measured and charged respectively, and after a sintering aid (boric acid, calcium carbonate) was added thereto, an organic binder and water were added and mixed, followed by drying and granulation to prepare mixed powder of nitride.

The mixed powder was filled in a mold and press-molded at a pressure of 5 MPa to obtain a molded body. Subsequently, the molded body was compressed by applying a pressure of 20 to 100 MPa using a cold isostatic pressing (CIP) apparatus (trade name: ADW800, manufactured by Kobe Steel, Ltd.). The compressed molded body was held at 2000°C for 10 hours and sintered using a batch-type high-frequency furnace (trade name: FTH-300-1H, manufactured by Fuji Dempa Kogyo Co., Ltd.) to prepare a boron nitride porous body. Firing was carried out by adjusting the inside of the furnace to a nitrogen atmosphere while flowing nitrogen into the furnace at a flow rate of 10 L/min in a standard state. The average pore diameter of the pores of the obtained boron nitride porous body was 3.5 pm. Moreover, the porosity of the obtained boron nitride porous body was 45.0% by volume.

(Preparation of Thermosetting Composition)

The following raw materials were used to prepare the thermosetting composition.

Epoxy compound: Trade name "HP-4032D", manufactured by DIC Corporation
Cyanate compound: Trade name "TA-CN", manufactured by Mitsubishi Gas Chemical Company, Inc.
Benzoxazine compound: Trade name "F-a type benzoxazine", manufactured by Shikoku Kasei Kogyo Co., Ltd.
Metal-based curing accelerator: Bis(2,4-pentanedionato) zinc (II), manufactured by Tokyo Chemical Industry Co., Ltd.

Into a container, 66 parts by mass of an epoxy compound, 23 parts by mass of a cyanate compound, and 11 parts by mass of a benzoxazine compound or an ester compound were charged. Further, with respect to a total of 100 parts by mass of the epoxy compound, the cyanate compound, and the benzoxazine compound, 0.01 parts by mass of a metal-based curing accelerator was put into the container. Then, these raw materials charged into the container were mixed while being heated to about 80°C to prepare a thermosetting composition.

(Filling of Thermosetting Composition into Voids of Porous Body)

The boron nitride porous body was impregnated with the thermosetting composition by the following method. First, the boron nitride porous body, and the thermosetting composition that had been in the container were placed in a vacuum heating impregnation apparatus (trade name: "G-555AT-R", manufactured by Kyoshin Engineering Co., Ltd.). Subsequently, the inside of the apparatus was deaerated for 10 minutes under conditions of a deaeration temperature of 100°C and a deaeration pressure of 15 Pa. After deaeration, while maintaining the same conditions, the boron nitride porous body was immersed in the above thermosetting composition for 40 minutes to impregnate the boron nitride porous body with the thermosetting composition.

Thereafter, the boron nitride porous body was further impregnated with the thermosetting composition by taking out the container containing the boron nitride porous body and the thermosetting composition, placing the container in a pressure heating impregnation apparatus (trade name "HP-4030AA-H45", manufactured by Kyoshin Engineering Co., Ltd.) and holding for 120 minutes under conditions of an impregnation temperature of 130°C and an impregnation pressure of 3.5 MPa. Thereafter, the boron nitride porous body impregnated with the thermosetting composition was taken out from the apparatus, and the boron nitride porous body impregnated with the thermosetting composition was heated for a predetermined time under conditions of a heating temperature of 120°C and an atmospheric pressure. As a result, the thermosetting composition was semi-cured, and a boron nitride porous body in which the voids were filled with the semi-cured product of the thermosetting composition was produced.

Using a wire saw, the obtained boron nitride porous body was sliced to fabricate a porous boron nitride sheet in which the voids of 50 mm × 50 mm × thickness 0.3 mm were filled with the semi-cured product of the thermosetting composition.

In addition to the porous boron nitride sheet, the following members were prepared to fabricate the circuit board.

Metal foil cut product 1: a product (size: 15 mm × 15 mm × 3 mm) obtained by punching a copper foil (trade name: "Oxygen-free copper cut plate JIS H3100 C1020P", thickness: 3 mm, manufactured by Hakudo Co., Ltd.) (see the metal foil cut product 20 in Fig. 1).

Metal foil cut product 2: a product (size: 15 mm × 15 mm × 1 mm) obtained by punching a copper foil (trade name: "Oxygen-free copper cut plate JIS H3100 C1020P", thickness: 1 mm, manufactured by Hakudo Co., Ltd.) (see the metal foil cut product 20 in Fig. 1).

Plate-shaped member 1: a copper foil (trade name: "Oxygen-free copper cut plate JIS H3100 C1020P", thickness: 3 mm, manufactured by Hakudo Co., Ltd.) cut into a size of 50 mm × 50 mm, on which four holes of 15 mm × 15 mm each were punched (see the plate-shaped member 30a in Fig. 1).

Plate-shaped member 2: a copper foil (trade name: "Oxygen-free copper cut plate JIS H3100 C1020P", thickness: 1 mm, manufactured by Hakudo Co., Ltd.) cut into a size of 50 mm × 50 mm, on which four holes of 15 mm × 15 mm each were punched (see the plate-shaped member 30a in Fig. 1).

Plate-shaped member 3: a Teflon (registered trademark) sheet (trade name: "PTFE sheet", thickness: 0.05 mm, manufactured by Chukoh Kasei Kogyo Co., Ltd.) cut into a size of 50 mm × 50 mm, on which four holes of 15 mm × 15 mm each were punched (see the plate-shaped member 30b in Fig. 1).

Plate-shaped member 4: a Teflon (registered trademark) sheet (trade name: "PTFE sheet", thickness: 0.05 mm, manufactured by Chukoh Kasei Kogyo Co., Ltd.) cut into a size of 50 mm × 50 mm, on which four holes of 15 mm × 15 mm each were punched (see the plate-shaped member 30b in Fig. 1).

Aluminum base plate: an aluminum plate (trade name: "high strength and high formability plate material (N532) 5052 material", thickness: 5 mm, manufactured by Nippon Light Metal Co., Ltd.) cut into a size of 50 mm × 50 mm.

Copper foil 1: a copper foil (trade name: "Oxygen-free copper cut plate JIS H3100 C1020P", thickness: 3 mm, manufactured by Hakudo Co., Ltd.) cut into a size of 15 mm × 15 mm.

Copper foil 2: a copper foil (trade name: "Oxygen-free copper cut plate JIS H3100 C1020P", thickness: 1 mm, manufactured by Hakudo Co., Ltd.) cut into a size of 15 mm × 15 mm.

[Fabrication of Circuit Board 1]

A porous boron nitride sheet was placed on an aluminum base plate, the plate-shaped member 3 was placed on the porous boron nitride sheet, the plate-shaped member 1 was placed on the plate-shaped member 3, and four metal foil cut products 1 were placed on the porous boron nitride sheet by fitting the metal foil cut products 1 into the openings of the plate-shaped member 1 and the plate-shaped member 3 to fabricate a laminate. While heating the obtained laminate at a heating temperature of 180°C, the laminate was pressurized at a pressure of 15 MPa for 1 hour. Thereafter, while pressurizing the laminate at a pressure of 1 MPa, the laminate was heated at a heating temperature of 150°C for 6 hours, heated at a heating temperature of 180°C for 4 hours, heated at a heating temperature of 200°C for 4 hours, and heated at a heating temperature of 250°C for 4 hours to obtain a circuit board 1 (see the circuit board lAin Fig. 5 (e)).

[Fabrication of Circuit Board 2]

A porous boron nitride sheet was placed on an aluminum base plate, the plate-shaped member 4 was placed on the porous boron nitride sheet, the plate-shaped member 2 was placed on the plate-shaped member 4, and the metal foil cut product 1 was placed on the porous boron nitride sheet by fitting the metal foil cut products 1 into the openings of the plate-shaped member 2 and the plate-shaped member 4 to fabricate a laminate. While heating the obtained laminate at a heating temperature of 180°C, the laminate was pressurized at a pressure of 15 MPa for 1 hour. Thereafter, while pressurizing the laminate at a pressure of 1 MPa, the laminate was heated at a heating temperature of 150°C for 6 hours, heated at a heating temperature of 180°C for 4 hours, heated at a heating temperature of 200°C for 4 hours, and heated at a heating temperature of 250°C for 4 hours to obtain a circuit board 2 (see the circuit board IAin Fig. 5 (e)).

[Fabrication of Circuit Board 3]

A circuit board 3 was fabricated in the same manner as the circuit board 1 except that the plate-shaped member 1 and the plate-shaped member 3 were not arranged and the pressure for bonding was changed from 15 MPa to 5 MPa.

[Fabrication of Circuit Board 4]

A circuit board 4 was fabricated in the same manner as the circuit board 2 except that the plate-shaped member 2 and the plate-shaped member 4 were not arranged and the pressure for bonding was changed from 15 MPa to 5 MPa.

[Fabrication of Circuit Board 5]

A circuit board 5 was fabricated in the same manner as the circuit board 1 except that the plate-shaped member 1 and the plate-shaped member 3 were not arranged.

[Fabrication of Circuit Board 6]

A circuit board 6 was fabricated in the same manner as the circuit board 2 except that the plate-shaped member 2 and the plate-shaped member 4 were not arranged.

[Fabrication of Circuit Board 7]

A porous boron nitride sheet was placed on an aluminum base plate, and the copper foil 1 was placed on the porous boron nitride sheet to fabricate a laminate. While heating the obtained laminate at a heating temperature of 180°C, the laminate was pressurized at a pressure of 10 MPa for 1 hour. Thereafter, while pressurizing the laminate at a pressure of 1 MPa, the laminate was heated at a heating temperature of 150°C for 6 hours, heated at a heating temperature of 180°C for 4 hours, heated at a heating temperature of 200°C for 4 hours, and heated at a heating temperature of 250°C for 4 hours. Thereafter, a dry film resist was laminated on the copper foil 1, and a photomask was used to irradiate only the portion of the dry film resist corresponding to the metal pattern with UV light to cure only the portion of the dry film resist corresponding to the metal pattern. Then, after the dry film resist was developed, a sulfuric acid/hydrogen peroxide etchant was used to remove the portion of the copper foil of the laminate where the dry film resist was not laminated, and the dry film resist was peeled off to fabricate a circuit board 7 having four electrodes of 15 mm × 15 mm × 3 mm on a surface thereof in the same manner as the circuit board 1.

[Fabrication of Circuit Board 8]

A circuit board 8 having four electrodes of 15 mm × 15 mm × 1 mm on a surface thereof was fabricated in the same manner as the circuit board 7 except that the copper foil 2 was used instead of the copper foil 1.

[Evaluation Method]

The following evaluations were performed on the fabricated circuit boards 1 to 8.

(Cracks Present or Not)

The periphery of a circuit pattern of the porous boron nitride sheet of the circuit board was visually observed to check for cracks in the porous boron nitride sheet.

(Insulation)

The dielectric breakdown voltage of the circuit board obtained as described above was evaluated. Specifically, a measuring electrode was placed in contact with the copper foil 1 or the copper foil 2 in oil, and the dielectric breakdown voltage was measured using a pressure resistance tester (apparatus name: TOS- 8700, manufactured by Kikusui Electronics Co., Ltd.) in accordance with JIS C2110-1:2016. From the measurement results, the insulation was evaluated according to the following criteria. The results are shown in Table 1.

A: The dielectric breakdown voltage is 4.5 kV or more
B: The dielectric breakdown voltage is 3.5 kV or more and less than 4.5 kV
C: The dielectric breakdown voltage is less than 3.5 kV

(Adhesion)

The adhesion state of the circuit board was checked with an ultrasonic flaw detector (trade name: "FSP8VA FineSAT", manufactured by Hitachi Power Solutions Co., Ltd.). In an ultrasonic flaw detection image, an unpeeled portion is indicated by a black portion in a joint. Therefore, the adhesion was evaluated based on the area of the black portion.

A: The area ratio of the black portion is 96 area% or more
B: The area ratio of the black portion is 90 area% or more and less than 96 area%
C: The area ratio of the black portion is 80 area% or more and less than 90 area%

(Shape of Side Surface of Metal Pattern)

The circuit board was cut in the thickness direction to prepare a sample that allows observation of the cross section of the circuit board. After embedding the cut sample in resin, a portion corresponding to the cross section of the circuit board of the sample was wet-polished using an automatic polisher. After drying the polished sample, a polished surface was coated with osmium. Then, using a scanning electron microscope (SEM) (trade name: "JCM-6000Plus", manufactured by JEOL Ltd.), a side surface of the metal pattern was observed, and the thickness of the metal pattern, the recess amount (d1) of the side surface of the metal pattern and the spread amount (d2) of the side surface of the metal pattern were measured. Thereafter, a value obtained by dividing the recess amount of the side surface of the metal pattern by the thickness of the metal pattern and a value obtained by dividing the spread amount of the side surface of the metal pattern by the thickness of the metal pattern were calculated. Since metal patterns are generally required to have vertical side surfaces, the shape characteristics of the side surfaces of the metal patterns were evaluated according to the following criteria.

A: Both the value obtained by dividing the recess amount of the side surface of the metal pattern by the thickness of the metal pattern and the value obtained by dividing the spread amount of the side surface of the metal pattern by the thickness of the metal pattern are 0.04 or less.
C: Both the value obtained by dividing the recess amount of the side surface of the metal pattern by the thickness of the metal pattern and the value obtained by dividing the spread amount of the side surface of the metal pattern by the thickness of the metal pattern are 0.055 or less, and at least one of the value obtained by dividing the recess amount of the side surface of the metal pattern by the thickness of the metal pattern and the value obtained by dividing the spread amount of the side surface of the metal pattern by the thickness of the metal pattern is greater than 0.04.
C: At least one of the value obtained by dividing the recess amount of the side surface of the metal pattern by the thickness of the metal pattern and the value obtained by dividing the spread amount of the side surface of the metal pattern by the thickness of the metal pattern is greater than 0.055.

Evaluation results of the above evaluations are shown in Table 1.

**Table 1**

| | | | Circuit board 1 | Circuit board 2 | Circuit board 3 | Circuit board 4 | Circuit board 5 | Circuit board 6 | Circuit board 7 | Circuit board 8 |
|---|---|---|---|---|---|---|---|---|---|---|
| | | | Ex. | Ex. | Ex. | Ex. | Comp. Ex. | Comp. Ex. | Comp. Ex. | Comp. Ex. |
| Metal pattern | Thickness | mm | 3 | 1 | 3 | 1 | 3 | 1 | 3 | 1 |
| | Recess amount (d1)/ thickness | - | 0 | 0 | 0 | 0 | 0 | 0 | 0 | 0.056 |
| | Spread amount (d2)/ thickness | - | 0 | 0 | 0 | 0 | 0 | 0 | 0.767 | 0 |
| Porous boron nitride sheet | Thickness | mm | 0.3 | 0.4 | 0.3 | 0.4 | 0.3 | 0.4 | 0.3 | 0.3 |
| | Cracks present or not | - | No | No | No | No | Present | Present | No | No |
| Aluminum base plate | Thickness | mm | 5 | 5 | 5 | 5 | 5 | 5 | 5 | 5 |
| Insulation | | | A | A | A | A | C | C | A | A |
| Adhesion | | | A | A | B | B | A | A | A | A |
| Shape characteristics of side surface of metal pattern | | | A | A | A | A | A | A | C | C |

It has been found that according to the method of producing the circuit board 1 and the circuit board 2 of the examples, no cracks occur in the porous boron nitride sheet even when the metal foil cut product is attached to the porous boron nitride sheet and pressurized. Further, it has been found that according to the method of producing the circuit board 3 and the circuit board 4 of the examples that do not use a plate-shaped member, no cracks occur in the porous boron nitride sheet when the metal foil cut product is attached to the porous boron nitride sheet and pressurized with a pressure of 1.0 to 8.0 MPa. On the other hand, it has been found that according to the method of producing the circuit board 5 and the circuit board 6 of the comparative examples that do not use a plate-shaped member, cracks are generated in the porous boron nitride sheet when the metal foil cut product is attached to the porous boron nitride sheet and pressurized with a pressure greater than 8.0 MPa. Further, it has been found from the circuit board 7 and the circuit board 8 of the comparative examples that when a metal pattern is formed by etching, one of the value obtained by dividing the recess amount of the side surface of the metal pattern by the thickness of the metal pattern and the value obtained by dividing the spread amount of the side surface of the metal pattern by the thickness of the metal pattern becomes greater than 0.055 mm, and the shape characteristics of the side surface of the metal pattern deteriorate. In addition, in the circuit board 7 and the circuit board 8 of the comparative examples, since the metal pattern was formed by etching, it took a long time to production the circuit boards.

Reference Signs List

    1, 1A: Circuit board
    2: Cured composite layer
    3: Metal pattern
    4, 50: Metal base plate
    10: Semi-cured composite sheet
    20: Metal foil cut product
    30: Plate-shaped member
    30a: First plate-shaped member
    30b: Second plate-shaped member
    41, 41A: First laminate
    42, 42A: Second laminate

**Claims**

1. A method of producing a circuit board by laminating a metal foil cut product obtained by cutting a metal foil on a semi-cured composite sheet that contains a porous ceramic and a semi-cured product of a thermosetting composition filling voids of the porous ceramic, the production method comprising:

       a step of placing, on the semi-cured composite sheet, a plate-shaped member having an opening that fits with the metal foil cut product;
       a step of fitting the metal foil cut product into the opening of the plate-shaped member and placing the metal foil cut product on the semi-cured composite sheet on which the plate-shaped member has been placed;
       a step of pressurizing, while heating, the semi-cured composite sheet on which the plate-shaped member and the metal foil cut product have been placed to produce a first laminate; and
       a step of removing the plate-shaped member from the first laminate to produce a second laminate,
       wherein an absolute value of a difference between a thickness of the metal foil cut product and a thickness of the plate-shaped member is 0.25 mm or less.

2. The method of producing a circuit board according to claim 1, wherein the plate-shaped member includes a first plate-shaped member having an opening that fits with the metal foil cut product, and a second plate-shaped member, which has an opening that fits with the metal foil cut product and which is a release sheet that prevents adhesion between the first plate-shaped member and the semi-cured composite sheet.

3. The method of producing a circuit board according to claim 1 or 2, wherein a material of the plate-shaped member or a material of the first plate-shaped member is the same as a material of the metal foil cut product.

4. The method of producing a circuit board according to any one of claims 1 to 3, further comprising a step of placing the semi-cured composite sheet on a metal base plate, wherein

the step of placing the plate-shaped member includes placing a plate-shaped member on the semi-cured composite sheet that has been placed on the metal base plate, and
the step of placing the metal foil cut product includes placing the metal foil cut product on the semi-cured composite sheet that has been placed on the metal base plate.

5. A circuit board production method of producing a circuit board by laminating a metal foil cut product obtained by cutting a metal foil on a semi-cured composite sheet that contains a porous ceramic and a semi-cured product of a thermosetting composition filling voids of the porous ceramic, the production method comprising

a step of placing the metal foil cut product on the semi-cured composite sheet; and
a step of producing a laminate by applying a pressure of 1.0 to 8.0 MPa while heating the semi-cured composite sheet on which the metal foil cut product has been placed.

6. The method of producing a circuit board according to any one of claims 1 to 5, further comprising a step of heating and curing the first laminate, the second laminate, or the laminate.

7. A circuit board comprising

a cured composite layer containing a porous ceramic and a cured product of a thermosetting composition filling voids of the porous ceramic, and
a metal pattern provided on a surface of the cured composite layer, wherein a value obtained by dividing a recess amount of a side surface of the metal pattern by a thickness of the metal pattern and a value obtained by dividing a spread amount of the side surface of the metal pattern by the thickness of the metal pattern are 0.055 or less, and
the circuit board has a dielectric breakdown voltage of 3.5 kV or more.

8. The circuit board according to claim 7, further comprising a metal base plate provided on a surface opposite to a surface of the cured composite layer on the metal pattern side.

Fig. 1

# Fig. 2

(a)

(b)

(c)

(d)

# Fig. 3

(a)

(b)

# Fig. 4

# Fig .5

(a)

10
50

(b)

31
30b
10
50

(c)

31
$\left.\begin{array}{c}30a\\30b\end{array}\right\}30$
10
50

(d)

20    41A
$\left.\begin{array}{c}30a\\30b\end{array}\right\}30$
10
50

(e)

42A(1A)
20(3)
10(2)
50(4)

## INTERNATIONAL SEARCH REPORT

| International application No. |
| --- |
| **PCT/JP2022/006515** |

**A.    CLASSIFICATION OF SUBJECT MATTER**

*C04B 38/00*(2006.01)i; *H05K 3/20*(2006.01)i
FI:    H05K3/20 Z; C04B38/00 303Z

According to International Patent Classification (IPC) or to both national classification and IPC

**B.    FIELDS SEARCHED**

Minimum documentation searched (classification system followed by classification symbols)

C04B38/00; H05K3/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| Y | JP 2020-136349 A (MITSUBISHI MATERIALS CORP) 31 August 2020 (2020-08-31) paragraphs [0017]-[0062], fig. 1-5 | 1, 4-8 |
| Y | WO 2020/203692 A1 (DENKA COMPANY LIMITED) 08 October 2020 (2020-10-08) paragraphs [0011]-[0050] | 1, 4-8 |
| A | WO 2020/111045 A1 (NHK SPRING CO LTD) 04 June 2020 (2020-06-04) entire text, all drawings | 1-8 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **09 May 2022** | **17 May 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT
### Information on patent family members

International application No.

**PCT/JP2022/006515**

| Patent document<br>cited in search report | Publication date<br>(day/month/year) | Patent family member(s) | Publication date<br>(day/month/year) |
|---|---|---|---|
| JP 2020-136349 A | 31 August 2020 | (Family: none) | |
| WO 2020/203692 A1 | 08 October 2020 | (Family: none) | |
| WO 2020/111045 A1 | 04 June 2020 | (Family: none) | |

Form PCT/ISA/210 (patent family annex) (January 2015)

**EP 4 299 550 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009049062 A
- WO 2017155110 A